# EUROPÄISCHE PATENTANMELDUNG

(11) **EP 0 861 927 A1**
(43) Veröffentlichungstag der Anmeldung: **02.09.1998**
(21) Anmeldenummer: 97810091.5
(22) Anmeldetag: 24.02.1997
(51) Int. Cl.: C30B 11/00

(54) **Verfahren zum Herstellen von einkristallinen Strukturen**

(71) Anmelder: SULZER INNOTEC AG, CH-8401 Winterthur (CH)
(72) Erfinder: Kurz, Wilfried, 1025 St. Sulpice (CH); Gäumann, Matthias, 1110 Morges (CH); Bieler, Hans-Werner, 8404 Winterthur (CH); Wagnière, Jean-Daniel, 1004 Lausanne (CH); Rusterholz, Hansjakob, CH-8406 Winterthur (CH)
(74) Vertreter: Hammer, Bruno Dr.

(57) **Zusammenfassung**

Beim Verfahren zum Herstellen von einkristallinen Strukturen, Teilen oder Werkstücken aus metallischen Superlegierungen, auf Substraten mit einkristalliner Struktur oder einkristallinen Strukturen, wird mit einem Energiestrahl hoher Energiedichte von einer Energiequelle, die Oberfläche des Substrats aufgeschmolzen. Dem geschmolzenen Bereich des Substrates wird das Material zugeführt, das in die einkristalline Struktur gebracht werden soll. Das zugeführte Material wird vollständig aufgeschmolzen. Die Energiezufuhr mit dem Energiestrahl wird so geregelt und/oder gesteuert, dass Erstarrungsgeschwindigkeit und Temperaturgradient im GV-Diagramm im dendritisch kristallinen Bereich, ausserhalb des globulitischen Bereichs liegen.

## Beschreibung

Die Erfindung bezieht sich auf ein Verfahren zum Herstellen von gerichtet erstarrten (directionally solidified) und einkristallinen Strukturen, insbesondere aus Superlegierungen nach dem Oberbegriff des unabhängigen Anspruchs 1.

Metallische Werkstücke mit einkristalliner Struktur werden als Teile von Maschinen verwendet, die im Betrieb hohen mechanischen, thermischen und/oder chemischen Belastungen ausgesetzt sind. Beispielsweise werden Schaufeln von Gasturbinen, insbesondere auch von Rotoren für Flugzeug-Triebwerke, aber auch solche für stationäre Gasturbinen, aus Einkristallen hergestellt. Die Fertigung von derartigen einkristallinen Werkstücken erfolgt z.B. durch gerichtetes Erstarren aus der Schmelze. Es handelt sich dabei um Giessverfahren, bei denen die flüssige metallische Legierung zur einkristallinen Struktur, d.h. zum einkristallinen Werkstück erstarrt.

Wenn in der vorliegenden Schrift von einkristalliner Struktur und einkristallinen Strukturen die Rede ist, so sind damit sowohl Einkristalle, die keine Korngrenzen aufweisen, als auch Kristallstrukturen, die wohl Korngrenzen die longitudinal verlaufen, aber keine Korngrenzen, die in transversaler Richtung verlaufen, aufweisen. Bei diesen zweitgenannten kristallinen Strukturen spricht man auch von gerichtet erstarrten Gefügen (directionally solidified structures).

Als Legierungen für diese Einkristall-Turbinenschaufeln werden sog. Superlegierungen auf Nickel- (Ni), Kobalt- (Co) oder Eisenbasis (Fe) verwendet. Besonders Superlegierungen auf Nickelbasis haben hervorragende mechanische und chemische Hochtemperatureigenschaften.

Aufgabe der Erfindung ist es, ein Verfahren zu schaffen, mit welchem es möglich ist, auf der einkristallinen Struktur eines Substrats einen Körper bzw. ein Werkstück mit ebenfalls einkristalliner Struktur aufzubauen. Nach der Erfindung ist das Verfahren durch die Merkmale des unabhängigen Anspruchs 1 gekennzeichnet. Die abhängigen Ansprüche beziehen sich auf vorteilhafte Ausführungsformen der Erfindung.

Die Erfindung schafft ein neuartiges Verfahren, mit dem es möglich ist, auf einem Substrat mit einkristalliner Struktur, bzw. einkristallinen Strukturen eine oder mehrere Schichten, bzw. einen Körper oder ein Werkstück mit einkristalliner Struktur aufzuhauen. Es handelt sich dabei um ein epitaktisches Verfahren, bei welchem die kristalline Struktur des Substrates von der Schicht oder den Schichten, die aufgebaut werden, übernommen wird.

Das Verfahren für den Aufbau von Einkristallen aus dem gleichen Werkstoff, angenähert gleichen oder verschiedenen Werkstoffen wie das Substrat, ermöglicht beispielsweise den Neuaufbau bzw. die Ergänzung von Werkstücken, die einkristalline Strukturen aufweisen und die beschädigt sind oder abgenutzt sind. Beispielsweise gibt es heute Rotorschaufeln von Gasturbinen, die aus Einkristallen von sog. metallischen Superlegierungen bestehen.

Einkristalline Werkstücke können zwar aus der Schmelze durch sog. gerichtetes Erstarren (directionally solidified) hergestellt werden. Aber auch solche mit gerichtetem Erstarren hergestellte Teile nützen sich ab. Bisher gibt es aber keine Möglichkeit, ein derartiges Werkstücke einkristallin oder gerichtet erstarrt zu reparieren / rekonditionieren, d.h. das einkristalline Gefüge eines abgenutzten Werkstücks wieder einkristallin aufzubauen. Mit dem neuen Verfahren ist es nun auch möglich, beschädigte und abgenutzte, einkristalline Werkstücke einkristallin zu rekonditionieren, d.h. die Kristallstruktur zu ergänzen und neu aufzubauen. Dabei wird auf dem Substrat, bei z.B. einer einkristallinen Rotorschaufel Schicht um Schicht einkristallin auf- und weitergebaut bis die ursprüngliche Grösse und Form des Werkstücks wieder erreicht ist.

Als Energie- bzw. Wärmequelle für das Durchführen des Verfahrens sind Laserstrahlen, Elektronenstrahlen aber auch Lichtbogenverfahren wie z.B. Micro-TIG oder Plasmaverfahren geeignet, also Energiequellen, mit denen es möglich ist, auf eine sehr kleine Fläche, bzw. in ein kleines Volumen hohe Energiemengen konzentriert einzubringen.

Der Strahl hoher Energie und Energiedichte wird auf die Oberfläche des Substrats gerichtet, so dass die Oberflächenschicht des Substrats leicht anschmilzt. Dem Arbeitsbereich des Strahls wird das Material in Pulverform oder in Form eines Drahts zugeführt. Das zugeführte Material wird ebenfalls geschmolzen. Das Schmelzen dieses zugeführten Materials kann im Flüssigbad der geschmolzenen Oberflächenschicht oder schon auf dem Weg zum Flüssigbad erfolgen. Der Vorgang läuft vorzugsweise unter Schutzgas und/oder im Vakuum ab.

Wenn nun das Erstarren der Schmelze unter Bedingungen abläuft, die ausserhalb des globulitischen Bereichs, also im Bereich, in welchem das verwendete Material gerichtet erstarrt liegt, erstarrt der Werkstoff in einkristalliner Form, wächst also als epitaktische Struktur auf dem Substrat. Bei Metallen spricht man von globulitischer Erstarrung, wenn dieses nicht gerichtet kristallisiert. Es bilden sich dann beim Übergang von gerichtet einkristallin auf ungerichtet notwendigerweise eine oder mehrere Korngrenzen aus, welche die Vorteile des Einkristalls zunichte machen.

Die einkristalline Struktur wird in Form von dünnen Schichten, Platten oder komplexen Formen von etwa einem Millimeter oder einem Bruchteil eines Millimeters übereinander, Schicht für Schicht aufgetragen.

Wenn das Substrat z.B. induktiv auf eine Vorwärmtemperatur im Bereich von 750°C bis 1100°C, gebracht wird und diese Temperatur z.B. während dem Aufbau aufrecht erhalten wird, werden die Spannungen im Substrat und im aufgebauten Einkristall, aber auch zwischen dem Substrat und der epitaktisch darauf aufgebauten kristallinen Struktur verringert, was zum Verhindern von Rekristallisation und Kriechen in der Kristallstruktur beiträgt.

Entspannungsglühen von Substrat und neu aufgebauter Einkristallschicht während etwa einer Stunde bei einer Temperatur im Bereich von etwa 1000°C bis 1250°C, für CMSX-4 bei ca. 1150°C und nachfolgendem langsamem abkühlen reduziert innere Spannungen, welche zur Zerstörung der einkristallinen Strukturen durch Rekristallisation und Kriechen führen könnten. Das Spannungsarmglühen könnte aber auch gleich nach dem Aufbringen der epitaktischen Schicht mit einer HF-Einrichtung erfolgen.

Das Verfahren wird nachstehend anhand von Ausführungsbeispielen des Verfahrens näher erläutert. Die Figuren dienen zur Erläuterung von wesentlichen Parametern des Verfahrens und zeigen schematisch eine Laservorrichtung, welche für das Durchführen des Verfahrens geeignet ist. Es zeigt:
- Fig. 1: das Temperaturgradient- / Erstarrungsgeschwindigkeits-Diagramm in doppeltlogarithmischer Darstellung, das sog. GV-Diagramm (GV für "gradient velocity" bzw. "Temperaturgradient / Erstarrungsgeschwindigkeit");
- Fig. 2 A und B: den kristallinen Aufbau eines nach dem Verfahren der Erfindung auf gebauten und rekonditionierten Werkstückes Werkstück;
- Fig. 3: schematisch eine Einrichtung, die bei der Durchführung des Verfahrens geeignet ist.
- Fig. 4: zeigt den verwendet werden kann und die geeignet, ist pulverförmiges Material in das Schmelzbad zu blasen.

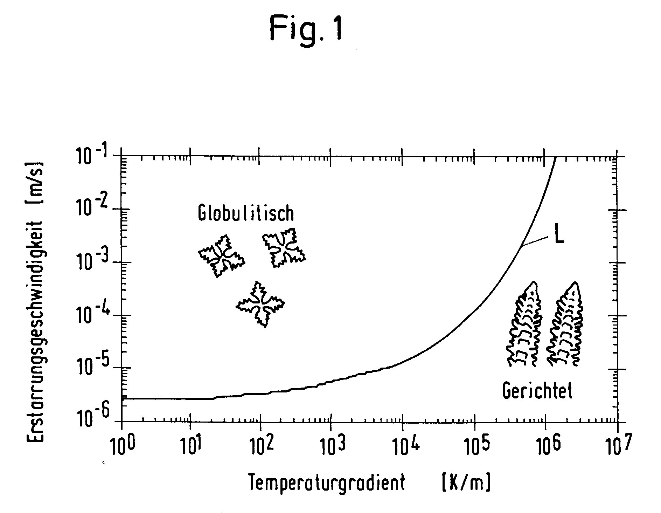

Die Fig. 1 zeigt das typische GV-Diagramm einer Superlegierung wie es z.B. für CMSX-4, einer Superlegierung auf Nickelbasis welche folgende Zusammensetzung in Gewichtsprozent hat:
C < 0.006; Cr 6.5; Co 9.7; Mo 0.6; W 6.4; Ti 1.0; Al 5.6; Ta 6.5; Re 3.0; Hf 0.09; Rest Ni.

Das GV-Diagramm ist für verschiede Metalle und metallische Legierungen unterschiedlich und für jede Legierung kann berechnet oder experimentell bestimmt werden. Die Kurve L trennt das GV-Diagramm den Bereich der beiden Parameter Erstarrungsgeschwindigkeit und Temperaturgradient in welchem die Legierung globulitisch erstarrt von jenem in welchem die Legierung zu einem dendritisch gerichteten Gefüge erstarrt. Eine Beschreibung und Erklärung des GV-Diagramms findet sich z.B. in Material Science Engineering Band 65 1984, in der Publikation J. D. Hunt über "Columnar to Equiangular Transition"

Wenn das Verfahren mit einem Laser durchgeführt wird, sollte bei einer Erstarrungsgeschwindigkeit von z.B. 10⁻³m/s der Temperaturgradient grösser als 4x10⁵ °K/m betragen, damit nach der Erfindung auf dem Substrat eine einkristalline Struktur epitaktisch aufwachsen kann (Epitaxie nennt man das orientierte Kristallwachstum auf einer kristallinen Unterlage, d.h. einer kristallinen Struktur).

Für das Verfahren heisst dies, dass z.B. der Laserstrahl mit einer Geschwindigkeit von etwa 10⁻³ m/s über das Substrat geführt werden muss, wenn die Energiezufuhr mit dem Laserstrahl so gewählt ist, dass zwischen dem Arbeitspunkt (der Punkt bzw. Bereich wo der Laserstrahl auf dem Flüssigbad auftrifft) im Flüssigbad und der Erstarrungsfront der Temperaturgradient im Bereich der Phasengrenze fest/flüssig in der Schmelze, von 6x10⁵ °K/m aufrecht erhalten wird.

In der Praxis wird die Geschwindigkeit, mit welcher der Laserstrahl über das Substrat geführt wird, im Bereich von 0.001 m/sec und 0.1 m/sec liegen. Entsprechend dem GV-Diagramm muss die Energie des Laserstrahls so eingestellt werden, dass der Temperaturgradient vom Arbeitspunkt zur Erstarrungsgrenze bzw. zur wandernden Erstarrungsfront, je nach gewählter Geschwindigkeit, grösser als etwa 10⁶ °K/m bis 1.5x10⁶ °K/m ist.

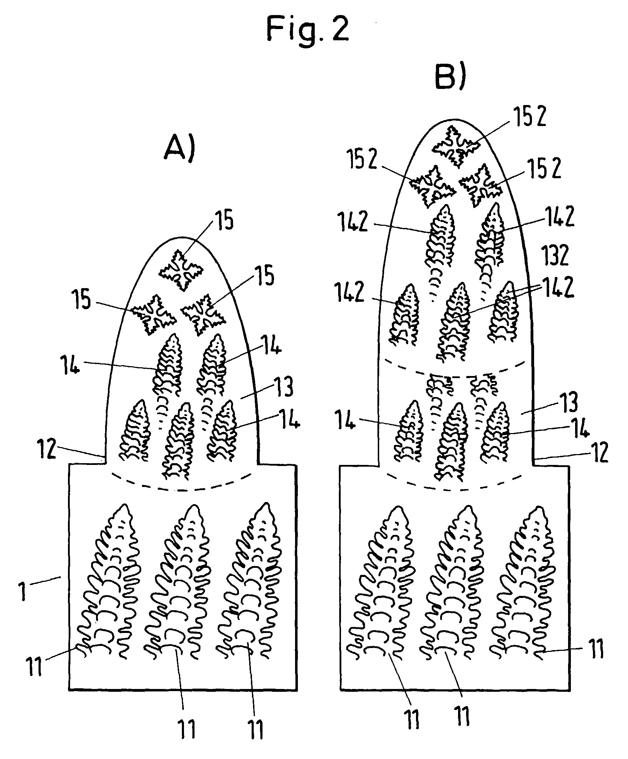

Wie in Fig. 2 A und B gezeigt, weist das Substrat 1 eine monokristalline, dendritische Struktur mit den Dendriten 11 auf. Alle Dendriten sind entlang der drei Raumachsen gleich orientiert. In Fig. 2A ist eine erste, auf dem Substrat nach dem Verfahren hergestellte, monokristalline, epitaktische Schicht schematisch dargestellt. Fig. 1B zeigt schematisch eine solche Struktur, die aus zwei Schichten aufgebaut ist. Der Aufbau der monokristallinen Struktur erfolgt in gleicher Weise durch Aufeinanderschichten einer beliebigen Zahl weiterer epitaktischer Schichten.

Diese Struktur wird an der Oberfläche mit dem Laserstrahl auf- und umgeschmolzen; dem flüssigen, geschmolzenen Bad wird das Material z.B. als Draht oder Pulver zugeführt (nicht gezeigt). Das zugeführte Material, das eine mono- oder polykristalline Struktur haben kann, wird in das aufgeschmolzenen Grundmaterial in der Umschmelzzone 12 eingebracht und vollständig geschmolzen. Dieses zugeführte Material, also z.B. das geschmolzene Pulver, erstarrt dann zu einer Schicht 13 zu einem dendritische Einkristall bzw. zu einem einkristallinen Gefüge mit einkristallinen Dendriten 14. Im oberen Grenzbereich bilden sich meist sog. Globuliten 15, d.h. eine Struktur, die als Nukleus für einen Dendriten dienen könnten, der die monokristalline Struktur stören könnte.
Beim Aufbringen der zweiten epitaktischen Schicht 132, werden die globulitischen Dendriten wieder auf- und umgeschmolzen und erstarren in Form von gerichteten Dendriten 142, d.h. als Einkristalle. Auch auf dieser zweiten epitaktischen Schicht 132 bilden sich auf der Oberfläche wieder globulitische Dendriten.

Einkristalline Strukturen können mit dem Verfahren der Erfindung beispielsweise mit CMSX-4 bei folgenden Bedingungen auf einem einkristallinen Substrat aus CMSX-4 aufgebaut werden:
- Lasertyp:: 1.5 kW CO₂ Laser
- Durchmesser Laserspot: : 2.5 mm (Durchmesser des Laserstrahls auf dem Substrat bzw. der vorangehenden Schicht)
- Pulver:: CMSX-4 Pulver mit einer Partikelgrösse (mesh) im Bereich von etwa 40 - 70 µm Durchmesser
- Schutzgas: Argon (Ar); 35 Liter/min

Bei der ersten Schicht (Spur) auf dem Substrat:

| | |
|---|---|
| Leistung Laser: | ca. 900 W |
| Geschwindigkeit Laserspot auf dem Substrat: | ca. 250 mm/Min (4.2 mm/sec) |

Bei der zweiten Schicht (Spur):

| | |
|---|---|
| Rückzug (Offset) Pulverspritzdüse | ca. 100 µm |
| hinter das Schmelzbad, relativ zur Verfahrensrichtung (für zweite Schicht) | |
| Leistung Laser: | ca. 600 W |
| Geschwindigkeit Laserspot: | ca. 500 mm/Min (8.4 mm/sec) |

Dritte und weitere Schichten (Spuren):

| | |
|---|---|
| Rückzug (Offset) Pulverspritzdüse: | ca. 70 µm |
| hinter das Schmelzbad, relativ zur Verfahrensrichtung | |
| Leistung Laser: | ca. 600 W |
| Geschwindigkeit Laserspot auf dem Substrat: | ca. 750 mm/Min |

Die erste Schicht wird auf das monokristalline Substrat aufgebracht; die zweite Schicht auf die epitaktisch erzeugte erste Schicht u.s.w. immer die nächstfolgende Schicht auf die vorhergehende.

Es ist zu beachten, dass das Wachsen einer monokristallinen Schicht voraussetzt, dass das zugeführte Material vollständig aufgeschmolzen wird. Wenn dies nicht der Fall ist, bilden z.B. nicht vollständig geschmolzene Pulverkörner Kristallisationskerne für Dendriten und Kristalle, welche das einkristalline Wachstum der Struktur stören und zerstören.

Beim Aufbau einer grösseren Struktur, bzw. eines grösseren Körpers mit dem epitaktischen Verfahren, bilden sich an der Oberfläche der zuletzt hergestellten Schicht globulitische Bezirke. Diese "equiaxed grains" sind Keime, welche das gerichtete Wachstum der Kristalle stören oder unterbrechen.

Beim Aufbau der nächsten, darüberliegenden Schicht ist es demnach von grosser Wichtigkeit, dass diese Globuliten vollständig aufgeschmolzen werden, so dass Dendriten, welche das monokristalline Gefüge zerstören würden verschwinden, bzw. unter der Oberfläche gar nicht entstehen.

Anderer Superlegierungen, mit denen sich nach dem Verfahren der vorliegenden Erfindung einkristalline Strukturen aufbauen lassen, sind beispielsweise IN 738LC, IN 939, IN 100, B 1914, CM 99, SRR 99, CM-247 LC, CMSX-2, CMSX-3, CMSX-6, Mar-M002

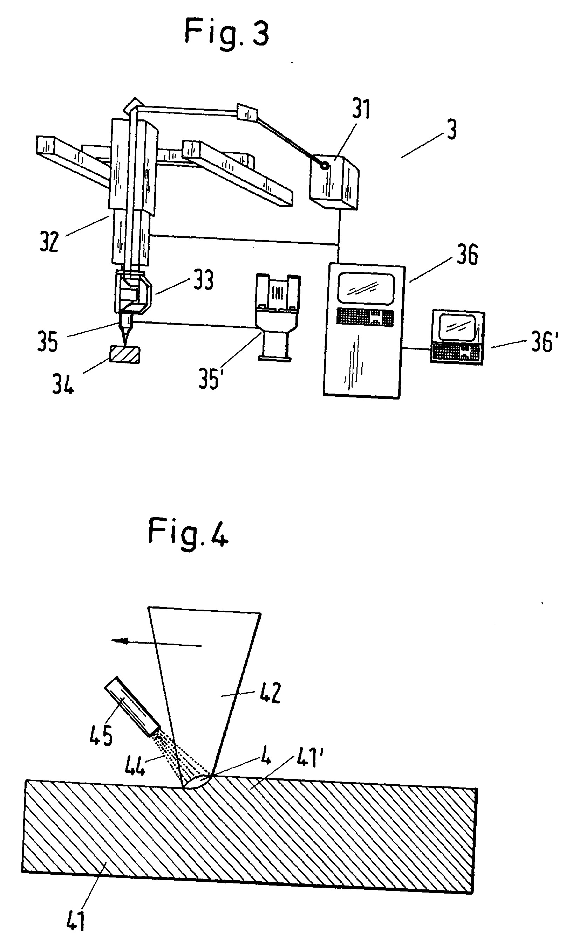

Die in Fig 3 schematisch gezeigte Anlage 3 zum Durchführen des Verfahrens umfasst den Laser, z.B. einen CO₂ -Laser 31. Der Strahl des Lasers 31 wird zum CNC-gesteuerten Strahlführungssystem 32 mit der Laserstrahl-Fokussieroptik 33 gelenkt und gelangt dann auf das Substrat bzw. Werkstück 34, auf welchem die kristalline Struktur aufgebaut werden soll. Die CNC-Anlage 36 welche den Prozess steuert und regelt, kann am Programmierplatz 36' programmiert werden. Der Pulverförderer 35' bringt das Material zum Beschichtungsmodul 35 und von dort wird das beispielsweise pulverförmige Material zum Schmelzbad auf dem Substrat 34 geführt/geblasen, wo das Material vorerst vollständig geschmolzen wird und dann zur einkristallinen Struktur erstarrt. Mit dem Beschichtungsmodul 35 kann auch der Schutzgasmantel erzeugt werden.

Fig. 4 schliesslich zeigt schematisch das z.B. einkristalline Substrat 41. Der Laserstrahl 42 schmilzt die Oberfläche des Substrats 41an. Es bildet sich das Schmelzbad 43, in welches das pulverförmige Material 44 von der Pulverdüse 45 zum Schmelzbad 43 geblasen wird. Der Laserstrahl und damit auch das Schmelzbad 43, eine Schmelzzone, bewegt sich in Richtung des Pfeils. Das Schmelzbad erstarrt zur epitaktischen Schicht 41, welche die kristalline Struktur des Substrats 41 aufweist.

Das Verfahren mit einem Elektronenstrahl als Energiequelle wird im Vakuum durchgeführt. Auch mit einem Laser als Energiequelle könnte das Verfahren im Vakuum durchgeführt werden. Im Vakuum ist zwar kein Schutzgas erforderlich, dafür kann das Manipulieren von Energiequelle, Substrat und zuzuführendem Werkstoff Probleme bringen. Darüber hinaus sind geeignete Vakuumkammern in der Regel nicht in beliebiger Grösse verfügbar.

Beim Verfahren zum Herstellen von einkristallinen Strukturen, Teilen oder Werkstücken aus metallischen Superlegierungen, auf Substraten mit einkristalliner Struktur oder einkristallinen Strukturen, wird mit einem Energiestrahl hoher Energiedichte von einer Energiequelle, die Oberfläche des Substrats aufgeschmolzen. Dem geschmolzenen Bereich des Substrates wird das Material zugeführt, das in die einkristalline Struktur gebracht werden soll. Das zugeführte Material wird vollständig aufgeschmolzen. Die Energiezufuhr mit dem Energiestrahl wird so geregelt und/oder gesteuert, dass Erstarrungsgeschwindigkeit und Temperaturgradient im GV-Diagramm im dendritisch kristallinen Bereich, ausserhalb des globulitischen Bereichs liegen.

## Patentansprüche

1. Verfahren zum Herstellen von einkristallinen Strukturen, Teilen oder Werkstücken aus metallischen Superlegierungen, auf Substraten mit einkristalliner Struktur oder einkristallinen Strukturen dadurch gekennzeichnet, dass
mit einem Energiestrahl einer Energiequelle die Oberfläche des Substrats aufgeschmolzen wird,
dem geschmolzenen Bereich das Material zugeführt wird, das in die einkristalline Struktur gebracht werden soll,
das zugeführte Material vollständig aufgeschmolzen wird und
die Energiezufuhr so geregelt und/oder gesteuert wird, dass Erstarrungsgeschwindigkeit und Temperaturgradient im GV-Diagramm im dendritisch kristallinen Bereich, ausserhalb des globulitischen Bereichs liegen.

2. Verfahren nach Anspruch 1, bei welchem als Energiestrahl hoher Energiedichte ein Laserstrahl, ein Elektronenstrahl, oder ein Lichtbogen verwendet wird.

3. Verfahren nach Anspruch 1 oder 2, bei welchem das Material, das in die einkristalline Struktur gebracht werden soll, in Pulverform oder in der Form eines Drahtes zugeführt wird.

4. Verfahren nach einem der Ansprüche 1 bis 3, bei welchem das zugeführte Material gleich ist wie jenes des Substrats oder
bei welchem das zugeführte Material verschieden ist und eine ähnliche Kristallstruktur wie das Material des Substrats aufweist.

5. Verfahren nach einem der Ansprüche 1 bis 4, bei welchem das Substrat und/oder das Material, das in eine einkristalline Struktur gebracht werden soll, eine metallische Superlegierung auf Co-Basis, oder auf Fe-Basis oder auf Ni-Basis, wie CMSX-4 ist.

6. Verfahren nach einem der Ansprüche 1 bis 5, bei welchem das Substrat auf eine Vorwärmtemperatur, vorzugsweise im Temperaturbereich von 800°C bis 1000°C vorgewärmt wird, wobei die Vorwärmtemperatur während dem Herstellen der epitaktischen Schicht, vorzugsweise konstant gehalten wird.

7. Verfahren nach Anspruch 6, bei welchem das Vorwärmen des Substrats induktiv erfolgt.

8. Verfahren nach einem der Ansprüche 1 bis 7, bei welchem die hergestellte kristalline Struktur nachfolgend, vorzugsweise bei einer Temperatur im Bereich von 1000°C bis 1250°C, vorzugsweise bei etwa 1150°C spannungsarmgeglüht wird.

9. Verfahren nach einem der Ansprüche 1 bis 8, das unter Schutzgas oder im Vakuum durchgeführt wird, wobei das Schutzgas im Verfahrensbereich vorzugsweise laminar oder weitgehend laminar fliesst.

10. Anwendung des Verfahrens nach einem der Ansprüche 1 bis 9 zum Ergänzen der einkristallinen Struktur einer abgenutzten einkristallinen Turbinenschaufel, insbesondere der Rotorschaufel einer Gasturbine oder eines Flugzeugtriebwerks.
